Europäisches Patentamt

European Patent Office

Office européen des brevets

(19)

(11) Veröffentlichungsnummer: **0 233 464 B1**

(12) **EUROPÄISCHE PATENTSCHRIFT**

(45) Veröffentlichungstag der Patentschrift: **21.11.91**

(21) Anmeldenummer: **87100331.5**

(22) Anmeldetag: **13.01.87**

(51) Int. Cl.⁵: **H04N 1/40**, H01L 27/14,
//H03F3/08,H04N5/335

(54) Schaltung zum Auslesen eines optoelektronischen Bildsensors.

(30) Priorität: **21.01.86 DE 3601658**

(43) Veröffentlichungstag der Anmeldung:
**26.08.87 Patentblatt 87/35**

(45) Bekanntmachung des Hinweises auf die
Patenterteilung:
**21.11.91 Patentblatt 91/47**

(84) Benannte Vertragsstaaten:
**DE FR GB IT NL**

(56) Entgegenhaltungen:
DE-B- 2 527 625
US-A- 4 011 442
US-A- 4 190 854

IEEE TRANSACTIONS ON COMPONENTS, HY-
BRIDS AND MANUFACTURING TECHNOLO-
GY, Band CHMT-7, Nr. 4, Dezember 1984,
Seiten 423-428, IEEE, New York, US; K. SUZU-
KI et al.: "High speed and high resolution
contact-type image sensor using an amorphous silicon photodetector array"

PATENT ABSTRACTS OF JAPAN, Band 7, Nr.
218 (E-200)[1363], 28.September 1983; & JP-

A-58 111 490

JAPANESE JOURNAL OF APPLIED PHYSICS,
Band 21, "Supplement" 21-1, Nr. 1, 1982, Seiten 245-249, Tokyo, JP; T. HAMANO et al.:
"An amorphous Si high speed linear image
sensor"

(73) Patentinhaber: **SIEMENS AKTIENGESELL-
SCHAFT**
**Wittelsbacherplatz 2**
**W-8000 München 2(DE)**

(72) Erfinder: **Brunst, Gerhard, Dr. rer. nat.**
**Hörwarthstrasse 25**
**W-8000 München 40(DE)**
Erfinder: **Evans, Andrew B.E.**
**32 Beach Street**
**Sth. Curlcurl 2096(AU)**
Erfinder: **Holzenkämpfer, Enno, Dr., rer.nat.**
**Biegenstrasse 20**
**W-3550 Marburg(DE)**
Erfinder: **Rohleder, Klaus, Dipl.-Ing.**
**Berger-Kreuz- Str. 56**
**W-8000 München 83(DE)**

## Beschreibung

Die Erfindung bezieht sich auf eine Schaltung zum Auslesen eines optoelektronischen Bildsensors nach dem Oberbegriff des Patentanspruchs 1.

Ein Bildsensor dieser Art ist dem Toshiba Review Nr. 149, Herbst 1984, S. 33-36, insbesondere Fig. 5, entnehmbar. Dabei entlädt der innerhalb einer bestimmten Integrationszeit von einer Fotodiode erzeugte Fotostrom die Diodenkapazität einschließlich der Eingangskapazität des über eine Verbindungsleitung angeschlossenen Operationsverstärkers sowie der parasitären Kapazitäten der Verbindungsleitung, so daß eine belichtungsabhängige Restspannung entsteht, die dann am Ausgang des Operationsverstärkers ein niederohmig abgreifbares Spannungssignal ergibt. Der zweite Anschluß jeder Fotodiode wird hier über einen elektronischen Schalter periodisch auf eine Bezugsspannung rückgesetzt, wobei das nachfolgende Öffnen dieses Schalters den Beginn der Integrationszeit bestimmt. Das Ende derselben wird durch das Schließen eines weiteren elektronischen Schalters definiert, der den Kanalausgang auf den Ausgang der Ausleseschaltung durchschaltet. Nachteilig ist jedoch, daß die genannten parasitären Kapazitäten sowie die Kapazität der Fotodiode im allgemeinen von Auslesekanal zu Auslesekanal differieren und deswegen die Größe der erhaltenen Spannungssignale unterschiedlich beeinflussen. Außerdem verkleinern die parasitären Kapazitäten und die Eingangskapazität des Verstärkers das Signal-Rausch-Verhältnis der Spannungssignale ganz erheblich. Ein weiterer Nachteil besteht in der je nach der Beleuchtungsintensität unterschiedlichen Spannung an den einzelnen Fotodioden, da Spannungsdifferenzen zwischen benachbarten Fotodioden die an den entsprechenden Kanalausgängen zur Verfügung stehenden Spannungssignale beeinflussen.

US-A-4 011 442 beschreibt einen Bildsensor mit einer Mehrzahl von Sensorelementen, deren Ausgänge sequentiell auf einen Ausgang durchgeschaltet werden, und bei dem eine einen Differenzverstärker enthaltende Integrationsschaltung zur Integration der von den Sensorelementen gelieferten Fotoströme verwendet wird.

Der Erfindung liegt die Aufgabe zugrunde, einen Bildsensor der eingangs genannten Art anzugeben, bei dem die oben aufgeführten Nachteile weitgehend vermieden werden. Das wird durch eine Ausbildung nach dem kennzeichnenden Teil des Patentanspruchs 1 erreicht.

Der mit der Erfindung erzielbare Vorteil liegt insbesondere darin, daß von den Sensorelementen des Bildsensors eine Mehrzahl von Spannungssignalen abgeleitet werden, die der Belichtung der einzelnen Sensorelemente proportional sind, ein großes Signal-Rausch-Verhältnis aufweisen und von den jeweils benachbarten Auslesekanälen praktisch nicht beeinflußt werden. Die Gleichmäßigkeit der bei gleichmäßiger Belichtung der einzelnen Sensorelemente in diesen erzeugten Fotoströme wird bei einem erfindungsgemäß ausgebildeten Bildsensor durch die Herstellungstoleranzen der einzelnen Auslesekanäle nicht beeinträchtigt.

Die Ansprüche 2 bis 7 betreffen bevorzugte Ausgestaltungen und Weiterbildungen der Erfindung.

Die Erfindung wird nachfolgend anhand von in der Zeichnung dargestellten bevorzugten Ausführungsbeispielen näher erläutert. Dabei zeigt:

Fig. 1 eine bevorzugte Ausgestaltung eines erfindungsgemäßen Bildsensor-Auslesekanals,

Fig. 2 eine mit einer Mehrzahl von Auslesekanälen ausgestattete erfindungsgemäße Bildsensor-Ausleseschaltung und

Fig. 3 den prinzipiellen Aufbau eines mit einer Ausleseschaltung nach Fig. 2 versehenen linearen Bildsensors.

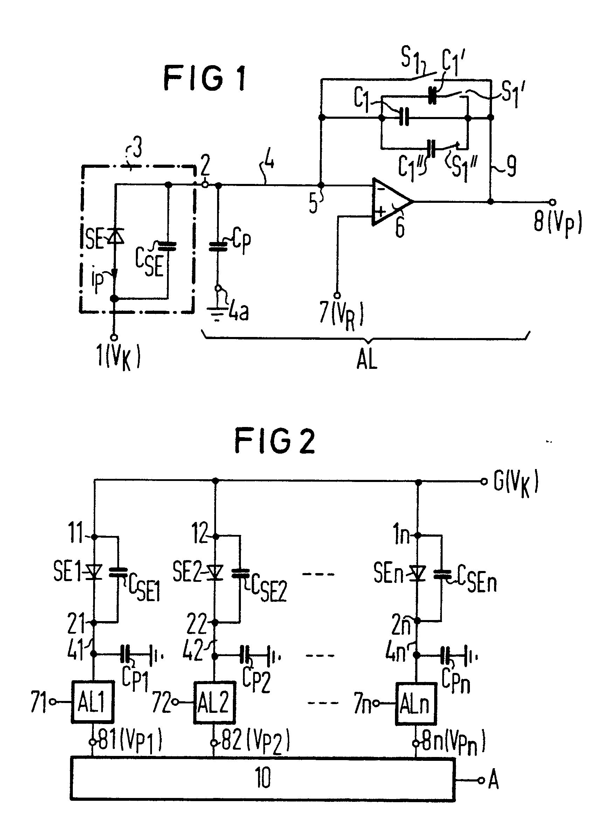

In Fig. 1 ist die Ersatzschaltung eines in einem optoelektronischen Bildsensor enthaltenen Sensorelements innerhalb des gestrichelten Rahmens 3 dargestellt. Dabei wird das mit den Anschlüssen 1 und 2 versehene Sensorelement durch eine mit SE bezeichnete Diode angedeutet, seine Kapazität durch einen zwischen diesen Anschlüssen eingefügten Kondensator $C_{SE}$. Der Anschluß 1 ist mit einer Konstantspannung $V_K$ beschaltet. Der Anschluß 2 ist über eine Verbindungsleitung 4 an den negativen Eingang 5 eines Differenzverstärkers 6 geführt, dessen positiver Eingang 7 mit einer Referenzspannung $V_R$ belegt ist. Der Ausgang 8 des Differenzverstärkers 6, der vorzugsweise als Operationsverstärker realisiert sein kann, ist mit dem negativen Eingang 5 über einen Rückkopplungszweig 9 verbunden, in den eine Integrationskapazität C1 eingefügt ist. Der letzteren ist ein elektronischer Schalter S1 parallel geschaltet, der vorzugsweise aus einem MIS-FET besteht. Die Eingangskapazität am negativen Eingang 5 und die parasitären Kapazitäten der Verbindungsleitung 4 gegenüber dem Massepotential sind zu einer Kapazität $C_P$ zusammengefaßt. Dabei ist $C_P$ zwischen die Leitung 4 und ein Schaltungspunkt 4a eingezeichnet, der auf Massepotential liegt. Die zwischen den Schaltungspunkten 2 und 8 liegenden Schaltungsteile bilden einen Auslesekanal AL, der dem Sensorelement SE zugeordnet ist.

Fig. 2 zeigt eine Bildsensor-Ausleseschaltung mit einer Mehrzahl von Sensorelementen SE1...SEn, denen eine Mehrzahl von Auslesekanälen AL1...ALn, die jeweils entsprechend AL in Fig. 1 aufgebaut sind, individuell zugeordnet sind. Dabei sind die Bezugszeichen der den einzelnen Sensorelementen zugeordneten, aus Fig. 1 ersichtlichen Schaltungsteile zum Unterschied von Fig. 1 durch eine entsprechende Zusatzzahl, z.B. "1", für die Zuordnung zu SE1, "2" für die Zuordnung zu SE2 usw., ergänzt. Die ersten Anschlüsse 11...1n der Sensorelemente SE1...SEn sind mit einem gemeinsamen Anschluß G verbunden, der mit der Konstantspannung $V_K$ beschaltet ist. Die Kanalausgänge 81...8n sind mit zugeordneten Eingängen einer Teilschaltung 10 verbunden, die die Kanalausgänge jeweils einzeln nacheinander auf den Ausgang A der Ausleseschaltung durchschaltet. Die Teilschaltung 10 kann mit Vorteil aus einer Reihe von Feldeffekt-Schalttransistoren bestehen, die jeweils die Schaltungspunkte 81, 82 usw. mit dem Ausgang A verbinden und über die Ausgänge eines Schieberegisters nacheinander angesteuert werden.

Die Referenzspannung $V_R$ am positiven Eingang 7 des rückgekoppelten Differenzverstärkers 6 bewirkt, daß der negative Eingang 5, die Verbindungsleitung 4 und der Anschluß 2 ständig auf einem konstanten Potential gehalten werden, das $V_R$ entspricht. Beim Auslesen des beleuchteten Sensorelements SE wird zunächst C1 durch Schließen des elektronischen Schalters S1 entladen. Anschließend wird S1 geöffnet, was dazu führt, daß der Fotostrom $i_P$, der von dem Sensorelement SE erzeugt wird, in der Kapazität C1 integriert wird. Dabei baut sich am Kanalausgang 8 ein Spannungssignal $V_P$ auf, das beim Durchschalten des Kanalausgangs über die Teilschaltung 10 an den Ausgang A der Ausleseschaltung gelangt. Die Zeitspanne zwischen dem Öffnen des Schalters S1 und der Durchschaltung des Kanalausgangs wird als Integrationszeit bezeichnet. Das Spannungssignal $V_P$ am Kanalausgang 8 ist dabei von der Intensität der Beleuchtung des Sensorelements SE und von der Länge der Integrationszeit abhängig. Da die Verbindungsleitung 4 und der Anschluß 2 über den Differenzverstärker 5 während der gesamten Integrationszeit auf konstantem Potential gehalten werden, findet keine Umladung von $C_{SE}$ und $C_P$ durch den Fotostrom $i_P$ statt, so daß $V_P$ durch $C_{SE}$ und $C_P$ nicht beeinflußt wird.

Die Verbindungsleitungen 41...4n und die Anschlüsse 21...2n von SE1...SEn liegen wegen der Zuführung von $V_R$ an die positiven Eingänge 71...7n sämtlicher Differenzverstärker jeweils auf demselben Potential, und zwar auch bei einer ungleichmäßigen Beleuchtung der einzelnen Sensorelemente. Dadurch werden die an den Signalausgängen 81...8n abgreifbaren Spannungssignale $V_{P1}...V_{Pn}$ durch die jeweils benachbarten Auslesekanäle nicht beeinflußt.

Nach einer in Figur 1 dargestellten Weiterbildung der Erfindung werden jeder der Integrationskapazitäten, z.B. C1, kleinere Trimmkondensatoren C1′ und C1″ parallel geschaltet. Diese sind über Schalter S1′ bzw. S1″ wahlweise zu- oder abschaltbar. Obwohl in Figur 1 aus Gründen der Übersichtlichkeit nur zwei Trimmkondensatoren gezeigt sind, können jeder Integrationskapazität auch mehrere Trimmkondensatoren parallel geschaltet werden. Hierdurch gelingt es, die wirksame Integrationskapazität, d.h. C1, gegebenenfalls ergänzt durch C1′..., so einzustellen, daß am Kanalausgang 8 ein Spannungssignal $V_P$ der gewünschten Größe auftritt. Insbesondere können Ungleichmäßigkeiten der einzelnen Auslesekanäle AL1...ALn durch eine kompensierende Einstellung der Trimmkondensatoren ausgeglichen werden.

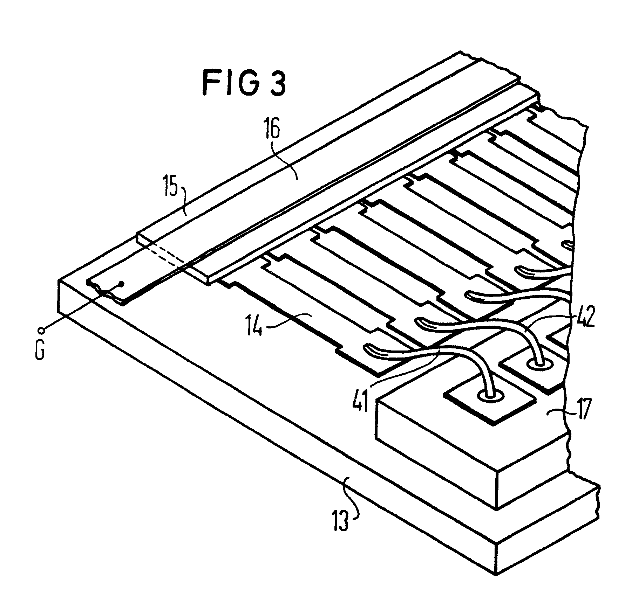

Der in Fig. 3 dargestellte hybride Bildsensor weist ein isolierendes Substrat 13 auf, auf dem eine Reihe von z.B. aus Chrom bestehenden Metallelektroden 14 nebeneinander angeordnet sind. Oberhalb der endseitigen, etwas verbreiterten Abschnitte derselben befindet sich eine dünne Fotoleiterschicht in Form eines Streifens 15 von etwa 1 µm Dicke. Der Streifen 15 besteht mit Vorteil aus a-Si:H. Sein mittlerer Bereich ist mit einer transparenten Elektrode 16 belegt, die z.B. aus Indium-Zinnoxid (ITO) besteht und über den endseitigen Anschluß G mit einer negativen Konstantspannung $V_K$ beschaltet ist. Die rechtsseitigen Enden der Elektroden 14 sind über Verbindungsleitungen 41, 42 usw. mit den Differenzverstärkern der einzelnen Auslesekanäle AL1, AL2 usw. verbunden, die in einem auf dem Substrat 13 befestigten, dotierten Halbleiterkörper 17 monolithisch integriert sind. Jeder einzelne der verbreiterten Abschnitte der Elektroden 14 bildet zusammen mit den über ihm befindlichen Teilen des Streifens 15 und der Elektrode 16 eine Fotodiode, die einem Sensorelement 3 von Fig. 1 entspricht.

Die Länge eines nach Fig. 3 ausgebildeten Bildsensors kann z.B. der einen Abmessung eines abzutastenden Dokuments entsprechen, das dann in Richtung seiner anderen Abmessung an dem Bildsensor vorbeibewegt wird. Dabei sind nur sehr einfache nicht verkleinernde optische Hilfsmittel zwischen der abzutastenden Dokumentenfläche und dem Bildsensor anzuordnen. Der grundsätzliche Aufbau eines derartigen Bildsensors ist z.B. dem obengenannten Toshiba Review zu entnehmen.

Abweichend von den bisher beschriebenen Ausgestaltungen des Bildsensors nach der Erfindung kann der Streifen 15 auch aus einem anderen Fotoleitermaterial bestehen, so z.B. aus CdS-CdSe. Die Sensorelemente SE1...SEn können auch zusammen mit der Ausleseschaltung in einem einzigen dotierten Halbleiterkörper, z.B. aus Si, monolithisch integriert sein, wobei die einzelnen Sensorelemente dann durch Halbleitergebiete gebildet werden, die in den Halbleiterkörper eingefügt und entgegengesetzt zu diesem dotiert sind. Die Länge eines solchen monolithisch integrierten, linearen Bildsensors ist dann allerdings wesentlich kleiner als die des in Fig. 3 dargestellten.

Im Rahmen der Erfindung liegen auch Ausführungsformen des Bildsensors, bei denen die Sensorelemente nicht linear angeordnet sind, sondern eine flächenhafte Verteilung aufweisen. Insbesondere können mehrere lineare Bildsensoren nach Fig. 3 auf einem gemeinsamen Substrat 13 zusammengefaßt sein.

Bezugszeichenliste

| 1, 2 | Anschlüsse eines Sensorelements |
| 3 | gestrichelter Rahmen |
| 4 | Verbindungsleitung |
| 4a | Schaltungspunkt |
| 5 | negativer Eingang von 6 |
| 6 | Differenzverstärker |
| 7 | positiver Eingang von 6 |
| 8 | Ausgang von 6 |
| 9 | Rückkopplungszweig |
| 10 | Teilschaltung |
| 11...1n | Anschlüsse der Sensorelemente |
| 13 | Substrat |
| 14 | Metallelektroden |
| 15 | Streifen |
| 16 | transparente Elektrode |
| 17 | Halbleiterkörper |
| 21...2n | Anschlüsse der Sensorelemente |
| 41...4n | Verbindungsleitungen |
| 81...8n | Kanalausgänge |
| A | Ausgang der Ausleseschaltung |
| AL | Auslesekanal |
| AL1...ALn | Auslesekanäle |
| $C_1$ | Integrationskapazität |
| $C_1'$, $C_1''$ | Trimmkondensatoren |
| $C_P$ | parasitäre Kapazitäten der Verbindungsleitung 4 und Eingangskapazität an 5 |
| $C_{SE}$ | Kapazität von SE |
| G | gemeinsamer Anschluß |
| $i_P$ | Fotostrom |
| S1 | elektronischer Schalter |
| $S1'$, $S1''$ | Schalter |
| SE | Sensorelement |
| SE1...SEn | Sensorelement |
| $V_K$ | Konstantspannung |
| $V_P$ | Spannungssignal |
| $V_{P1}...V_{Pn}$ | Spannungssignale |
| $V_R$ | Referenzspannung |

**Patentansprüche**

1. Schaltung zum Auslesen eines optoelektronischen Bildsensors, der eine Mehrzahl von über ihre ersten Anschlüsse (1) mit einer Konstantspannung belegte Sensorelemente (SE1...SEn) aufweist, bei der den Sensorelementen Auslesekanäle (AL1...ALn) individuell zugeordnet sind, die an die zweiten Anschlüsse (21...2n) der Sensorelemente geschaltet sind und zur Ableitung von belichtungsabhängigen Spannungssignalen dienen, bei der in jedem Auslesekanal (AL) ein mit einem Rückkopplungszweig (9) versehener Differenzverstärker (6) angeordnet ist, dessen Ausgang den Kanalausgang (8) bildet, und bei der eine Teilschaltung (10) vorgesehen ist, die die an den Kanalausgängen (8) oder an einem Teil derselben auf-tretenden Spannungssignale sequentiell auf ei-nen Ausgang (A) durchschaltet, **dadurch gekennzeichnet,** daß der positive Eingang (7) des Differenzverstärkers (6) mit einer Referenzspannung beschaltet ist, daß sein negativer Eingang (5) mit dem zweiten Anschluß (2) des dem Auslesekanal (AL) zugeordneten Sensorelements (SE) direkt verbunden ist, daß der Rückkopplungszweig (9) eine Kapazität (C1) enthält, in der der von dem Sensorelement (SE) gelieferte Fotostrom integriert wird, und daß ein der Kapazität (C1) parallel geschalteter elektronischer Schalter (S1) geöffnet wird, um den Beginn einer vorgegebenen Integrationszeit zu definieren.

2. Schaltung nach Anspruch 1, **dadurch gekennzeichnet,** daß der Bildsensor eine Mehrzahl von metallischen Elektroden (14) aufweist, die auf einem isolierenden Substrat (13) nebeneinander angeordnet sind, daß die endseitigen Abschnitte der Elektroden (14) von einem Streifen (15) aus fotoleitendem Material überdeckt sind, daß der Streifen (15) mit einer transparenten Elektrode (16) belegt ist und daß diese mit der Konstantspannung beschaltet ist.

3. Schaltung nach Anspruch 2, **dadurch gekennzeichnet,** daß der Streifen (15) aus a-Si:H besteht.

4. Schaltung nach Anspruch 2 oder 3, **dadurch gekennzeichnet,** daß die transparente Elektrode (16) aus Indium-Zinnoxid besteht.

5. Schaltung nach einem der Ansprüche 2 bis 4, **dadurch gekennzeichnet,** daß die metallischen Elektroden (14) mit den negativen Eingängen der Differenzverstärker (6) beschaltet sind und daß die Differenzverstärker (6) in ei-nem dotierten Halbleiterkörper (17) monoli-thisch integriert sind.

6. Schaltung nach Anspruch 5, **dadurch gekennzeichnet,** daß die Teilschaltung (10) in dem dotierten Halbleiterkörper (17) mitintegriert ist.

7. Schaltung nach einem der Ansprüche 1 bis 6, **dadurch gekennzeichnet,** daß der im Rückkopplungszweig (9) enthaltenen Kapazität (C1) Trimmkondensatoren (C1′, C1″) wahlweise parallel schaltbar sind.

## Claims

1. Circuit for reading an optoelectronic image sensor which has a multiplicity of sensor elements (SE1.. SEn) supplied via their first terminals (1) with a constant voltage, in which read channels (AL1...ALn) are individually assigned to the sensor elements and connected to the second terminals (21...2n) of the sensor elements and serve for deriving illumination-dependent voltage signals, in which in each read channel (AL) a differential amplifier (6) provided with a feedback branch (9) is arranged, the output of which forms the channel output (8), and in which a subcircuit (10) is provided which sequentially connects through to an output (A) the voltage signals occurring at the channel outputs (8) or at a part thereof, characterised in that the positive input (7) of the differential amplifier (6) is connected to a reference voltage, in that its negative input (5) is directly connected to the second terminal (2) of the sensor element (SE) assigned to the read channel (AL), in that the feedback branch (9) contains a capacitor (C1) in which the photocurrent supplied by the sensor element (SE) is integrated, and in that an electronic switch (S1) connected parallel to the capacitor (C1) is opened in order to define the start of a prescribed integration time.

2. Circuit according to Claim 1, characterised in that the image sensor has a multiplicity of metallic electrodes (14) which are arranged next to one another on an insulating substrate (13), in that the end-side sections of the electrodes (14) are covered by a strip (15) of photoconductive material, in that the strip (15) has a transparent electrode (16) located on top of it and in that the said electrode is connected to the constant voltage.

3. Circuit according to Claim 2, characterised in that the strip (15) consists of a-Si:H.

4. Circuit according to Claim 2 or 3, characterised in that the transparent electrode (16) consists of indium stannic oxide.

5. Circuit according to one of Claims 2 to 4, characterised in that the metallic electrodes (14) are connected to the negative inputs of the differential amplifiers (6), and in that the differential amplifiers (6) are monolithically integrated in a doped semi-conductor body (17).

6. Circuit according to Claim 5, characterised in that the subcircuit (10) is also integrated in the doped semi-conductor body (17).

7. Circuit according to one of Claims 1 to 6, characterised in that trimming capacitors (C1', C1") can be optionally connected in parallel to the capacitor (C1) contained in the feedback branch (9).

## Revendications

1. Circuit pour lire un détecteur d'images optoélectronique, qui comporte une multiplicité d'éléments formant capteurs (SE1...SEn), auxquels une tension constante est appliquée par l'intermédiaire de leurs premières bornes (1), et dans lequel, aux éléments formant capteurs, sont associés individuellement des canaux de lecture (AL1...ALn), qui sont raccordés aux secondes bornes (21...2n) des éléments formant capteurs et sont utilisés pour obtenir des signaux de tension qui dépendent de l'éclairage, et dans lequel, dans chaque canal de lecture (AL), est disposé un amplificateur différentiel (6) pourvu d'une branche de réaction (9), dont la sortie forme la sortie (8) du canal, et dans lequel il est prévu un circuit partiel (10) qui transmet directement et séquentiellement les signaux de tension qui apparaissent au niveau des sorties (8) des canaux ou sur une partie de ces sorties, à une sortie (A), caractérisé par le fait que l'entrée positive (7) de l'amplificateur différentiel (6) est placée à une tension de référence, que son entrée négative (5) est raccordée directement à la seconde borne (2) de l'élément formant capteur (SE) associé au canal de lecture (AL), que la branche de réaction (9) comporte une capacité (C1) dans laquelle le courant photoélectrique délivré par l'élément formant capteur (S1) est intégré, et qu'un interrupteur électronique (S1), qui est branché en parallèle avec la capacité (C1), est ouvert pour définir le début d'une durée d'intégration prédéterminée.

2. Circuit suivant la revendication 1, caractérisé par le fait que le détecteur d'images possède une multiplicité d'électrodes métalliques (14), qui sont disposées côte-à-côte sur un substrat isolant (13), que les sections, situées sur le côté extrémité des électrodes (14) sont recouvertes par une bande (15) formée d'un matériau photoconducteur, que la bande (15) est recouverte par une électrode transparente (16) et que cette dernière est raccordée à la tension constante.

3. Circuit suivant la revendication 2, caractérisé par le fait que la bande (15) est formée par du a-Si:H.

4. Circuit suivant la revendication 1 ou 2, caractérisé par le fait que l'électrode transparente (16) est constituée par de l'oxyde d'indium-étain.

5. Circuit suivant l'une des revendications 1 à 4, caractérisé par le fait que les électrodes métalliques (14) sont raccordés aux entrées négatives des amplificateurs différentiels (6) et que les amplificateurs différentiels (6) sont intégrés de façon monolithique dans un corps semiconducteur dopé (17).

6. Circuit suivant la revendication 5, caractérisé par le fait que le circuit partiel (10) est intégré simultanément dans le corps semiconducteur dopé (17).

7. Circuit suivant l'une des revendications 1 à 6, caractérisé par le fait que des condensateurs d'ajustage (C1',C1") peuvent être branchés au choix en parallèle avec la capacité (C1) contenue dans la branche de réaction (9).

## FIG 1

## FIG 2

# FIG 3